# EUROPEAN PATENT APPLICATION

(11) **EP 4 621 026 A1**
(43) Date of publication of application: **24.09.2025**
(21) Application number: 23891401.4
(22) Date of filing: 06.11.2023
(51) Int. Cl.: C09K 3/14, B24B 37/00, C09G 1/02, H01L 21/304

(54) **POLISHING COMPOSITION**

(30) Priority: 18.11.2022 JP 2022184697
(71) Applicant: Sumitomo Metal Mining Co., Ltd., Tokyo (JP)
(72) Inventor: AOKI, Katsutoshi, Tokyo 105-0004 (JP)
(74) Representative: TBK
(86) International application number: PCT/JP2023/039881
(87) International publication number: WO 2024/106249

(57) **Abstract**

[Abstract] Provided is a polishing composition that suppresses the generation of abrasive grain agglomerates, has good dispersibility of abrasive grains, and is capable of obtaining a highly smooth surface without generating polishing scratches on the surface to be polished.

The polishing composition comprising; a diamond abrasive grain, a polyhydric alcohol, pure water, and a dispersant, wherein a content of the diamond abrasive grain is 0.01-0.4 mass%, wherein an average particle size D₅₀ of the diamond abrasive grains is 10 nm-1 µm, wherein the content of the polyhydric alcohol is 1 to 40 mass%, and wherein the dispersant is at least one of an organic acid salt, an inorganic acid salt, and an octylphenol ethoxylate-based surfactant.

## Description

### Technical field

The present invention relates to a polishing composition, for example, a polishing composition used for polishing polycrystalline SiC substrates.

### Background Art

Silicon carbide (SiC) is a wide band gap semiconductor with a wide band gap of 2.2-3.3 eV. Due to its excellent physical and chemical properties, research and development is being conducted on it as an environmentally resistant semiconductor material. In particular, in recent years, SiC has attracted attention as a material for high-voltage and high-power electronic devices, high-frequency electronic devices, and short-wavelength optical devices from blue to ultraviolet, and research and development of SiC has been active. However, it is difficult to manufacture high-quality large-diameter single crystals of SiC, which has hindered the practical use of SiC devices. For this reason, there has been a strong demand for the development of technology that can provide SiC substrates for semiconductor devices, especially for high-voltage and high-power electronic devices, at low cost.

Therefore, a technology has been provided for manufacturing a semiconductor substrate that combines low cost (support substrate portion) and high quality (SiC portion) by using high-quality single crystal SiC only for the device formation layer portion and fixing it to the bonding surface of a support substrate (a material with strength, heat resistance, and cleanliness sufficient to withstand the device manufacturing process: for example, polycrystalline SiC) using a bonding method that does not involve the formation of an oxide film at the bonding interface to form a bonded substrate (see, for example, Patent Literature 1).

In the bonding process for bonding a single crystal SiC substrate and a polycrystalline SiC substrate when manufacturing a bonded substrate, the surface roughness of the bonding surface of the polycrystalline SiC substrate is important. The reason for this is that if the surface roughness of the polycrystalline SiC substrate, that is, the fine irregularities on the surface becomes large, the polycrystalline SiC substrate and the single crystal SiC substrate will not adhere closely enough to each other and cannot be bonded. Even if they can be bonded, the surface roughness of the polycrystalline SiC substrate is so large that minute gaps may occur at the bonding interface between the polycrystalline SiC substrate and the single crystal SiC substrate, resulting in numerous defects (bonding defects) in the bonded substrate.

Polycrystalline SiC substrates are formed by growing polycrystalline SiC on a base substrate made of, for example, carbon, by chemical vapor deposition (CVD), and then removing the base substrate.

The arithmetic surface roughness Ra of the bonding surface of the polycrystalline SiC substrate used in the bonding process for bonding the single crystal SiC substrate and the polycrystalline SiC substrate is required to be approximately 0.1-0.5 nm. To achieve this surface roughness, the bonding surface is subjected to, for example, CMP (chemical mechanical polishing) to obtain a CMP-polished surface, but the appearance of the polished surface will differ from that of the single crystal SiC substrate depending on the characteristics (crystal structure) of the polycrystalline SiC substrate. In other words, single crystal SiC is one large crystal grain oriented in the same direction, so the surface to be polished of the single crystal SiC substrate can be polished uniformly by CMP, and a highly accurate polished surface with low surface roughness can be easily obtained compared to a polycrystalline SiC substrate. On the other hand, since polycrystalline SiC is an aggregate of small crystal grains oriented in various directions, the polishing speed of the surface to be polished during CMP differs depending on each crystal grain, and the amount of wear differs depending on each crystal grain. As a result, the surface to be polished is prone to numerous irregularities along the grain boundaries, and it is more difficult to obtain a polished surface with low surface roughness in the case of polycrystalline SiC compared to a single crystal SiC substrate.

### Citation List

### Patent Literature

Patent Literature 1: JP 2015-15401 A

### Summary of the invention

### Problems to be solved by the invention

In addition to CMP, mechanical polishing using a combination of diamond particles and a metal surface plate is known as a method for obtaining a highly accurate polished surface in a polycrystalline SiC substrate. Since polycrystalline SiC substrates are an aggregate of crystal grains facing in various directions, CMP, which includes a chemical action in the polishing mechanism, may cause surface roughness due to the difference in etching rate between each polycrystalline grain. On the other hand, mechanical polishing, which does not include a chemical action, is less likely to cause surface roughness specific to polycrystalline SiC substrates, as occurs in CMP. Therefore, mechanical polishing can finish the polished surface of polycrystalline SiC substrates with high precision compared to CMP.

On the other hand, mechanical polishing has the disadvantage that it is difficult to obtain a smooth surface because cutting marks and processing distortion remain. In order to obtain a smooth polished surface in mechanical polishing, the particle size of the abrasive grains is important. The smaller the particle size, the better the smoothness and the more it is possible to suppress scratches on the polished surface. However, the abrasive grains used in mechanical polishing are dispersed in a dispersion medium such as a liquid and used in a slurry state, but when dispersing the abrasive grains in a liquid, the smaller the particle size of the abrasive grains, the more likely they are to aggregate and settle, and the resulting aggregated powder can be a factor in generating scratch marks such as scratches on the polished surface. For this reason, even when abrasive grains having the small particle size are used, scratches deeper than the grain size of the abrasive may occur on the polished surface.

In addition, a dispersant is generally added to disperse the abrasive in the dispersion medium, but if there is insufficient dispersant, the abrasive may not disperse sufficiently in the dispersion medium and may produce agglomerated powder, while if there is too much dispersant, the dispersed abrasive particles may tend to settle to the bottom of the dispersion medium, and the settled particles may become agglomerated powder. In other words, whether there is a shortage or an excess of dispersant, there is a risk of scratches occurring on the polished surface of the polycrystalline SiC substrate.

In order to solve the above problems, the present invention aims to provide a polishing composition that is particularly designed for polishing polycrystalline SiC, suppresses the generation of agglomerated powder of abrasive grains, has good dispersibility of abrasive grains, and can obtain a highly smooth surface without generating polishing scratches on the surface to be polished.

### Solution to Problem

In order to solve the above problems, the polishing composition of the present invention is a polishing composition comprising a diamond abrasive grain, a polyhydric alcohol, pure water, and a dispersant, wherein the content of the diamond abrasive grain is 0.01-0.4 mass%, wherein the average particle diameter D₅₀ of the diamond abrasive grain is 10 nm-1 µm, wherein the content of the polyhydric alcohol is 1-40 mass%, and wherein the dispersant is at least one of an organic acid salt, an inorganic acid salt, or an octylphenol ethoxylate-based surfactant.

The diamond abrasive grain may be either a single crystal diamond abrasive grain or a polycrystalline diamond abrasive grain.

The polyhydric alcohol may be ethylene glycol.

The dispersant may be at least one of sodium hexametaphosphate or octylphenoxypolyethoxyethanol.

When the dispersant is the organic acid salt and/or the inorganic acid salt, the total content of the organic acid salt and/or the inorganic acid salt may be 0.003-0.15 mass%.

When the dispersant is the octylphenol ethoxylate-based surfactant, the content of the octylphenol ethoxylate-based surfactant may be 0.0025-0.07 mass%.

The polishing composition of the present invention may be a polishing composition used for polishing a polycrystalline SiC substrate.

### Advantageous Effects of The Invention

The present invention can provide a polishing composition that suppresses the generation of agglomerated powder of abrasive grains, has good dispersibility of abrasive grains, and can obtain a highly smooth surface without generating polishing scratches on the surface to be polished.

### Detailed Description of Embodiments

Below, one embodiment of the polishing composition of the present invention will be described in detail.

The present invention is a polishing composition used for mechanical polishing. In particular, when the object to be polished is a polycrystalline SiC substrate, the composition can improve the smoothness of the polished surface and prevent scratches from occurring on the surface to be polished due to polishing.

### [Polishing composition]

The polishing composition of the present invention contains a diamond abrasive grain, a polyhydric alcohol and pure water as dispersion media, and a dispersant. Each raw material will be described in detail below.

### <Diamond abrasive grain>

Diamond is preferably used as an abrasive grain when polishing difficult-to-machine materials such as polycrystalline SiC substrates, because its high hardness makes it easy to maintain cutting properties in various slurry compositions.

As the diamond abrasive grain, a single crystal diamond abrasive grain or a polycrystalline diamond abrasive grain may be used, or these may be used in combination. In addition, as the diamond abrasive grain, abrasive grain made of artificial diamond or natural diamond may be used, or these may be used in combination.

The average particle size of the diamond abrasive grains (D₅₀ value measured by a particle size distribution meter, volume basis. The type, method, and model of the particle size distribution meter are not particularly specified as long as they are suitable for measuring the particle size) is 10 nm-1 µm. In mechanical polishing, the particle size of the diamond abrasive grain is important to obtain a smooth polished surface using the diamond abrasive grain. The smaller the particle size of the diamond abrasive grain, the more the smoothness of the polished surface can be improved and the occurrence of scratches on the surface to be polished can be suppressed. However, if the particle size of the diamond abrasive grain is too small, the abrasive grain may aggregate, making it impossible to improve the smoothness of the polished surface and prevent the occurrence of scratches on the surface to be polished. Therefore, the lower limit of the average particle size D₅₀ of the diamond abrasive grains is set to 10 nm.

In addition, by polishing with the polishing composition of the present invention, it is necessary to adjust the arithmetic surface roughness Ra of the surface of the polycrystalline SiC substrate to 0.5 nm or less. Therefore, the average particle size D₅₀ of the diamond abrasive grain is 1 µm or less, more preferably 100 nm or less.

By using such small diamond abrasive grain with an average particle size D₅₀ of 10 nm-1 µm, the occurrence of scratches on the polished surface can be suppressed and the smoothness of the polished surface can be improved as described above. On the other hand, diamond abrasive grain with an average particle size D₅₀ in the range of 10 nm-1 µm tend to have extremely poor dispersibility in the dispersion medium compared to particles larger than 1 µm, so the concentration ratio of the diamond abrasive grain to the polyhydric alcohol, the pure water, and the dispersant in the polishing composition is more important to satisfy the dispersibility.

That is, the content of diamond abrasive grain in the polishing composition is 0.01-0.4 mass%, preferably 0.05-0.25 mass%. The content of diamond abrasive grain in the polishing composition affects the polishing speed of the polishing surface and the occurrence of scratches. If the content is less than 0.01 mass%, the polishing speed of the polishing surface using the polishing composition may be extremely reduced, which is a factor in reducing the polishing efficiency. Also, if the content exceeds 0.4 mass%, the dispersibility of the diamond abrasive grain may be poor, causing the diamond abrasive grain to aggregate and cause scratches to occur on the polishing surface.

### <Dispersion medium>

The dispersion medium is a medium for dispersing diamond abrasive grain, specifically, polyhydric alcohol and pure water.

### (Polyhydric alcohol)

The polyhydric alcohol is an alcohol having two or more hydroxyl groups in the molecule, and there is no particular limitation on the number of carbon atoms or the number of hydroxyl groups, and examples thereof include alcohols with a valence of two or more. For example, polyhydric alcohols that are liquid at room temperature, such as ethylene glycol, propylene glycol, tripropylene glycol, butanediol, and glycerin, can be used. In particular, ethylene glycol is more preferable in terms of flammability and environmental load, as well as good solubility in water and low viscosity.

The content of polyhydric alcohol in the polishing composition is 1-40 mass%. Preferably, it is 5-35 mass%, and more preferably, it is 10-30 mass%.

If the content of polyhydric alcohol in the polishing composition is less than 1 mass%, the diamond abrasive grain may be difficult to disperse. For example, if the polishing composition does not contain polyhydric alcohol and the dispersion medium is pure water only, the diamond abrasive grain will not disperse and will aggregate.

If the content of polyhydric alcohol in the polishing composition exceeds 40 mass%, the precipitation of diamond fine particle caused by the diamond abrasive grain may be confirmed, and the dispersion stability may decrease. This precipitation occurs because, under conditions where the amount of diamond abrasive grain is excessive, the affinity between the diamond fine particles increases, causing the fine particles to reaggregate and precipitate.

### (Pure water)

In addition, a dispersion medium that has a high affinity for polyhydric alcohol should be used, and the pure water is used in the present invention.

The content of pure water in the polishing composition is the remaining amount of the diamond abrasive grain, the polyhydric alcohol, and the dispersant. Although it depends on the content of each of these components, the content of the pure water in the polishing composition is generally 59.7-99 mass%.

### <Dispersant>

Mainly dispersant that have a dispersing effect on diamond abrasive grain is added as an additive. When dispersing the abrasive grains of the diamond fine particles in a liquid, the smaller the abrasive grain size, the more likely they are to aggregate or precipitate in the liquid, and these aggregated powders of the abrasive grain cause problems such as scratches on the polished surface. If an attempt is made to compose a polishing composition using only diamond abrasive grain, polyhydric alcohol and pure water without using a dispersant, the diamond abrasive grain may aggregate. Therefore, the dispersant that has a dispersing effect on diamond abrasive grains is added.

As dispersants, at least one of organic acid salt, inorganic acid salt, or octylphenol ethoxylate-based surfactant can be used.

Examples of organic acid salt include sodium citrate, sodium tartrate, and sodium acetate, and examples of inorganic acid salt include sodium phosphate and sodium sulfate. Among these salts, phosphates are preferred, and for example, sodium hexametaphosphate can be added. Sodium hexametaphosphate has the effect of increasing the affinity of the diamond abrasive grain and the polyhydric alcohol for pure water in particular, and is preferably used as a dispersant.

Furthermore, as a dispersant, a surfactant having a polyoxyethylene chain as a hydrophilic group and an octylphenol group as a hydrophobic group can be added. Specifically, an octylphenol ethoxylate-based surfactant in which a polyoxyethylene chain and an octylphenol group are linked by an ether bond is preferred, and for example, polyoxyethylene (10) octylphenyl ether (octylphenoxypolyethoxyethanol), commonly known as Triton X-100, can be added. Polyoxyethylene (10) octylphenyl ether has the effect of increasing the affinity of the diamond abrasive grain and the polyhydric alcohol in particular, and is preferably used as a dispersant.

The organic acid salts, the inorganic acid salts, and the octylphenol ethoxylate-based surfactant may be used alone as dispersants, or may be used in combination. The organic acid salts, the inorganic acid salts, and the octylphenol ethoxylate-based surfactant each have a different mechanism for increasing the affinity of the diamond abrasive grain, the polyhydric alcohol, and the pure water, and a synergistic effect is expected by adding both, so both the organic acid salts and/or the inorganic acid salts and the octylphenol ethoxylate-based surfactant can be used. For example, at least one of sodium hexametaphosphate and octylphenoxypolyethoxyethanol can be used alone as a dispersant, or these may be used in combination.

When the organic acid salts and/or the inorganic acid salts are used as dispersants, that is, when only the organic acid salts are used as salts, only the inorganic acid salts are used as salts, or the organic acid salts and the inorganic acid salts are used in combination as salts, the total content of the organic acid salts and/or the inorganic acid salts in the polishing composition is preferably 0.003-0.15 mass%, more preferably 0.005-0.1 mass%. If the total content of the organic acid salts and/or the inorganic acid salts is less than 0.003 mass%, the diamond abrasive grain may aggregate in the polishing composition. For example, if no organic acid salts and no inorganic acid salts are added, the diamond abrasive grain may aggregate. If the total content of the organic acid salts and/or the inorganic acid salts exceeds 0.15 mass%, the diamond abrasive grain dispersed in the polishing composition may re-aggregate and cause precipitation. Here, the total content of the organic acid salts and/or the inorganic acid salts is the content of only the organic acid salt when only the organic acid salt is used as the salt, the content of only the inorganic acid salt when only the inorganic acid salt is used as the salt, and the total content of the organic acid salt and the inorganic acid salt when the organic acid salt and the inorganic acid salt are used in combination.

If an octylphenol ethoxylate-based surfactant is used as a dispersant, the content of the octylphenol ethoxylate-based surfactant in the polishing composition is preferably 0.0025-0.07 mass%, more preferably 0.0025-0.05 mass%. If the content of the octylphenol ethoxylate-based surfactant is less than 0.0025 mass%, the diamond abrasive grain may aggregate in the polishing composition. For example, if no octylphenol ethoxylate-based surfactant is added at all, the diamond abrasive grain may aggregate. If the content of the octylphenol ethoxylate-based surfactant exceeds 0.07 mass%, the diamond abrasive grain dispersed in the polishing composition may re-aggregate and precipitate.

### [Method of manufacturing the polishing composition]

The method of manufacturing the polishing composition is not particularly limited as long as it can disperse diamond abrasive grain to such an extent that scratches are not generated on the polishing surface. For example, the polishing composition can be manufactured by mixing the diamond abrasive grain, **the polyhydric** alcohol, and the dispersant in small amounts and blending them, and then adding the pure water to adjust the concentration of diamond abrasive grain to a desired concentration. The process of dispersing diamond abrasive grain can be performed by stirring, and dispersion can be performed using a planetary mixer or the like as necessary.

### Examples

The present invention will be explained in more detail below with examples, but the present invention is not limited to the following examples.

Diamond fine particles with an average particle size D₅₀ of 5 nm-1 µm were obtained as the diamond abrasive grain, and the diamond fine particles, ethylene glycol, sodium hexametaphosphate, octylphenoxypolyethoxyethanol, and pure water were mixed in the content concentrations shown in Table 1, and the diamond fine particles were thoroughly stirred and dispersed to manufacture the polishing compositions of the examples and comparative examples.

### [Evaluation of Dispersibility]

If the concentration of dispersant in the polishing composition is insufficient, the diamond fine particles do not disperse and remain at the bottom of the container as agglomerated powder. In order to evaluate the dispersibility of the diamond abrasive grain in the polishing composition, the polishing composition was left to stand for 1 hour after production, and the supernatant liquid generated in the polishing composition was transferred little by little to another container, and the dispersibility was evaluated based on whether or not agglomerates remained at the bottom of the container in which the polishing composition was placed. Tables 1-3 show the results of evaluation as follows: o (very good) when agglomerates could not be confirmed with the naked eye, Δ (good) when visible particles floated in the liquid, and × (not good) when a large amount of agglomerates remained at the bottom of the container.

### [Evaluation of Dispersion Stability]

If the concentration of dispersant in the polishing composition is excessive, the diamond fine particles are dispersed, but the dispersion state is unstable, and the phenomenon occurs in which the diamond fine particles gradually precipitate and settle at the bottom of the container after production of the polishing composition. In this case, the dispersion stability of the diamond abrasive grain in the polishing composition was evaluated. Specifically, for the polishing compositions with dispersibility of o or Δ in the above dispersibility evaluation, the supernatant liquid and the original residue were returned to the original container and mixed again to prepare a polishing composition, and then the polishing composition was transferred to a transparent container and left to stand for 24 hours. The dispersion stability was evaluated based on the presence or absence of precipitates of diamond fine particles after standing for 24 hours. Tables 1-3 show the results of evaluation as ∘ (very good) when no precipitates were visually confirmed in the polishing composition, Δ (good) when the particles in the liquid showed a gradation of light and dark, and × (not good) when precipitates were clearly confirmed.

### [Results of evaluation of dispersibility and dispersion stability]

In Comparative Examples 1 and 2 and Examples 1-4, the average particle diameter D₅₀ of the diamond abrasive grain was constant at 50 nm, and the content of the diamond abrasive grain and the ethylene glycol was constant, and the dispersibility and dispersion stability were evaluated when the type and content of the dispersant were changed. As a result, in Comparative Example 1, which does not contain a dispersant, the dispersibility of the diamond abrasive grain was poor, and many agglomerates were confirmed. Next, in Examples 1 and 2, which contained only one type of dispersant, the dispersibility was improved compared to Comparative Example 1, and although some agglomerates were confirmed, they were still suitable for polishing polycrystalline SiC substrate. And in Example 3, which contained two types of dispersants, the dispersibility was further improved, and no agglomerates were visually confirmed. Furthermore, in Example 3, the dispersion stability was very good, and no precipitate was confirmed even after leaving it to stand for 24 hours. Also, in Example 4 and Comparative Example 2, two types of dispersants were contained, and the content of the dispersant was doubled from Example 4 to Comparative Example 2. However, it was confirmed that if the concentration of the dispersant was too high, the diamond fine particles tended to settle, and the dispersion stability was deteriorated in Comparative Example 2. **In** particular, in Comparative Example 2, where the dispersant concentration was excessive, precipitates were clearly confirmed, and the dispersion stability was poor.

In Comparative Example 3 and Examples 5-9, the dispersibility and dispersion stability were evaluated when the content concentration of the dispersant was constant and the average particle diameter D₅₀ of the diamond abrasive grains was changed. As a result, in Comparative Example 3 with a particle size of 5 nm, a large amount of agglomerated powder was confirmed, and it was confirmed that sufficient dispersibility could not be obtained even if a dispersant was added. Examples 5-9 are examples in which the average particle size D₅₀ of diamond abrasive grains was gradually increased, but the dispersibility was evaluated as Δ in Example 5, and although the dispersibility was very good in Examples 6-9, it was confirmed that the dispersion stability tended to deteriorate as the average particle size D₅₀ of diamond abrasive grains increased.

Based on Example 9, in which the average particle size D₅₀ of diamond abrasive grains was increased and the dispersion stability was slightly decreased and evaluated as Δ, the concentration of the two types of dispersant was reduced to 1/5, respectively, to prepare the polishing composition of Example 10. As a result, the dispersion stability was improved by reducing the amount of dispersant, and no precipitate was observed in the polishing composition of Example 10 even after it was left to stand for 24 hours.

**[Table 1]**

| | Average particle size D₅₀(nm) | Content Concentration (mass%) | | | | | Dispersibility | Dispersion Stability |
|---|---|---|---|---|---|---|---|---|
| | | Component (1) | Component (2) | Component (3) | Component (4) | Component (5) | | |
| Comparative Example 1 | 50 | 0.2 | 30 | 0 | 0 | 69.8 | × | - |
| Example 1 | 50 | 0.2 | 30 | 0 | 0.025 | 69.8 | Δ | ○ |
| Example 1 to 2 | 50 | 0.2 | 30 | 0.05 | 0 | 69.8 | Δ | ○ |
| Example 3 | 50 | 0.2 | 30 | 0.05 | 0.025 | 69.7 | ○ | ○ |
| Example 4 | 50 | 0.2 | 30 | 0.1 | 0.05 | 69.7 | ○ | Δ |
| Comparative Example 2 | 50 | 0.2 | 30 | 0.2 | 0.1 | 69.5 | ○ | x |
| Comparative Example 3 | 5 | 0.2 | 30 | 0.05 | 0.025 | 69.7 | × | - |
| Example 5 | 10 | 0.2 | 30 | 0.05 | 0.025 | 69.7 | Δ | ○ |
| Example 6 | 100 | 0.2 | 30 | 0.05 | 0.025 | 69.7 | ○ | ○ |
| Example 7 | 300 | 0.2 | 30 | 0.05 | 0.025 | 69.7 | ○ | Δ |
| Example 8 | 600 | 0.2 | 30 | 0.05 | 0.025 | 69.7 | ○ | Δ |
| Example 9 | 1000 | 0.2 | 30 | 0.05 | 0.025 | 69.7 | ○ | Δ |
| Example 10 | 1000 | 0.2 | 30 | 0.01 | 0.005 | 69.7 | ○ | ○ |
| * Component (1):Diamond Particles, Component (2):Ethylene Glycol | | | | | | | | |
| Component (3):Sodium Hexametaphosphate, Component (4):Octylpntmoxypolyethoxyethanol | | | | | | | | |
| Component (5):Pure Water | | | | | | | | |

As shown in Table 2, polishing compositions (Examples 11-13, Comparative Examples 4-6) were prepared by changing the content of the diamond abrasive grain and the content of the ethylene glycol based on the polishing composition of Example 3, and the changes in their dispersibility and dispersion stability were confirmed.

In Examples 3, 11, 12, and Comparative Example 4, the changes in dispersibility and dispersion stability due to the change in the content of the diamond abrasive grain in the polishing composition were confirmed. When the content of the diamond abrasive grain was reduced from that of Example 3 as in Example 11, no problems occurred in either dispersibility or dispersion stability, but when the content of the diamond abrasive grain in the polishing composition was increased as in Example 12 and Comparative Example 4, a tendency was confirmed that dispersibility and dispersion stability decreased with the increase in the concentration.

In Examples 3, 13, and Comparative Examples 5 and 6, the changes in dispersibility and dispersion stability due to the change in the content of the ethylene glycol in the polishing composition were confirmed. In Example 13, in which the content of the ethylene glycol was somewhat reduced from that in Example 3, the dispersibility was slightly reduced, but no significant residual aggregates were observed, and the dispersion stability was very good. However, in Comparative Example 5, in which no ethylene glycol was contained, it was confirmed that the diamond fine particles were hardly dispersed, and the dispersion was evaluated as poor. In addition, in Comparative Example 6, in which the content of the ethylene glycol was excessive, the dispersibility of the diamond abrasive grain was very good, but the precipitation of the diamond abrasive grains was confirmed, and the dispersion stability was confirmed to be reduced.

**[Table 2]**

| | Average Particle Size D₅₀ (nm) | Content Concentration (mass%) | | | | | Dispersibility | Dispersion Stability |
|---|---|---|---|---|---|---|---|---|
| | | Component (1) | Component (2) | Component (3) | Component (4) | Component (5) | | |
| Example 3 | 50 | 0.2 | 30 | 0.05 | 0.025 | 69.7 | ○ | ○ |
| Example 11 | 50 | 0.05 | 30 | 0.05 | 0.025 | 69.8 | ○ | ○ |
| Example 12 | 50 | 0.4 | 30 | 0.05 | 0.025 | 69.5 | Δ | Δ |
| Comparative Example 4 | 50 | 1.0 | 30 | 0.05 | 0.025 | 68.9 | × | × |
| Example 13 | 50 | 0.2 | 10 | 0.05 | 0.025 | 89.7 | Δ | O |
| Comparative Example 5 | 50 | 0.2 | 0 | 0,05 | 0.025 | 99.7 | × | - |
| Comparative Example 6 | 50 | 0.2 | 60 | 0.05 | 0.025 | 39.7 | ○ | × |
| * Component (1 ):Diamond Particles, Component (2):Ethylene Glycol | | | | | | | | |
| Component (3):Sodium Hexametaphosphate, Component (4):Octylphenoxypolyethoxyethanol | | | | | | | | |
| Component (5):Pure Water | | | | | | | | |

A polishing experiment was conducted using the polishing compositions of Comparative Examples 1 and 2, and Examples 1 to 4. Specifically, when the polishing target surface of a polycrystalline SiC substrate was mechanically polished with the polishing composition using a metal surface plate, it was evaluated whether scratches were generated on the polished surface. In all examples, the mechanical polishing conditions were the same except for the polishing composition. The case where no scratches were generated was evaluated as ∘ (very good), the case where scratches were generated but only a few were generated was evaluated as Δ (good), and the case where countless scratches were generated was evaluated as × (not good). The experimental results are shown in Table 3.

When the polishing experiment was performed using the polishing composition of Comparative Example 1, which had poor dispersibility, numerous scratches occurred on the polished surface. The polishing composition of Comparative Example 1 contained numerous agglomerated particles, and these agglomerated particles were the cause of the scratches on the polished surface.

When the polishing compositions of Examples 1 and 2, which had improved dispersibility compared to Comparative Example 1, were used, scratches occurred on the polished surface, but the number of scratches was small and was at a level that could be used for mechanical polishing of the surface of a polycrystalline SiC substrate in the manufacture of bonded substrates. The reason for this improvement in polishing characteristics is that the number of agglomerated particles was reduced compared to the polishing composition of Comparative Example 1, which reduced the scratches on the polished surface.

When the polishing compositions of Examples 3 and 4, which had very good dispersibility, were used, no scratches occurred on the polished surface.

In addition, Comparative Example 2 is the polishing composition in which precipitated particles of diamond abrasive grain exist due to an excessive content of dispersant, and when this was used, several scratches occurred on the polished surface. This is because the diamond abrasive particles that settled at the bottom of the container reaggregated, causing scratches on the polished surface.

The tendency derived from the results shown in Table 3 shows that the polishing composition with very good dispersibility and dispersion stability is required because scratches on the polished surface occur in both cases of a decrease in the dispersibility of the diamond abrasive particles caused by a lack of dispersant and a decrease in the dispersion stability of the diamond abrasive particles caused by an excess of dispersant.

**[Table 3]**

| | Average Particle Size D₅₀ (nm) | Additive Concentration (mass%) | | Dispersibility | Dispersion Stability | Agitation during use | Scratches on Polished Surface |
|---|---|---|---|---|---|---|---|
| | | Component (3) | Component (4) | | | | |
| Comparative Example 1 | 50 | 0 | 0 | × | - | None | × |
| Example 1 | 50 | 0 | 0.025 | Δ | ○ | None | Δ |
| Example 2 | 50 | 0.05 | 0 | Δ | ○ | None | Δ |
| Example 3 | 50 | 0.05 | 0.025 | ○ | ○ | None | ○ |
| Example 4 | 50 | 0.1 | 0.05 | ○ | Δ | None | ○ |
| Comparative Example 2 | 50 | 0.2 | 0.1 | ○ | × | None | Δ |
| *Component (3):Sodium Hexametaphosphate | | | | | | | |
| Component (4):Octylphenoxypolyethoxyethanol | | | | | | | |

As described above, the present invention can provide the polishing composition that suppresses the generation of agglomerated powder of the abrasive particle, has good dispersibility of the abrasive particle, and can obtain a smooth surface with high smoothness without generating polishing scratches on the surface to be polished, and is therefore industrially useful.

## Claims

1. A polishing composition comprising
a diamond abrasive grain,
a polyhydric alcohol,
pure water,
and a dispersant,
wherein a content of the diamond abrasive grain is 0.01-0.4 mass%,
wherein an average particle diameter D₅₀ of the diamond abrasive grain is 10 nm-1 µm,
wherein the content of the polyhydric alcohol is 1-40 mass%, and
wherein the dispersant is at least one of an organic acid salt, an inorganic acid salt, or an octylphenol ethoxylate-based surfactant.

2. The polishing composition according to claim 1, wherein the diamond abrasive grain is either a single crystal diamond abrasive grain or a polycrystalline diamond abrasive grain.

3. The polishing composition according to claims 1 or 2, wherein the polyhydric alcohol is ethylene glycol.

4. The polishing composition according to claims 1 or 2, wherein the dispersant is at least one of sodium hexametaphosphate or octylphenoxypolyethoxyethanol.

5. The polishing composition according to claim 1, wherein when the dispersant is the organic acid salt and/or the inorganic acid salt, the total content of the organic acid salt and/or the inorganic acid salt is 0.003-0.15 mass%.

6. The polishing composition according to claim 1, wherein when the dispersant is the octylphenol ethoxylate-based surfactant, the content of the octylphenol ethoxylate-based surfactant is 0.0025 to 0.07 mass%.

7. The polishing composition according to claims 1 or 2, which is a polishing composition used for polishing a polycrystalline SiC substrate.
